# EUROPÄISCHE PATENTANMELDUNG

(11) **EP 0 886 302 A2**
(43) Veröffentlichungstag der Anmeldung: **23.12.1998**
(21) Anmeldenummer: 98201936.6
(22) Anmeldetag: 09.06.1998
(51) Int. Cl.: H01L 21/00

(54) **Reaktor zur Verarbeitung von Wafern mit einer Schutzvorrichtung**

(30) Priorität: 17.06.1997 DE 19725527
(71) Anmelder: Philips Patentverwaltung GmbH, 22335 Hamburg (DE); Koninklijke Philips Electronics N.V., 5621 BA Eindhoven (NL)
(72) Erfinder: Volle, Wolfgang, c/o Philips Patentverw.GmbH, 22335 Hamburg (DE)
(74) Vertreter: Schmalz, Günther, Dipl.-Ing.

(57) **Zusammenfassung**

Die Erfindung betrifft einen Reaktor (1) zur Verarbeitung von Wafern (7) mit wenigstens einer Prozeßkammer (5), wenigstens einer Transportkammer (2) mit einem Transportroboter (3) für die Wafer (7) und wenigstens einem Magazin (6) für Wafer (7) mit einem Hebemechanismus (12). Um einen besseren Schutz vor Beschädigung auch von in einem Magazin (6) abgelegten Wafern (7) zu gewährleistet, ist im Reaktor (1) eine optische Kontrollanordnung (13, 14, 15,16) zur Überwachung der Position der in einem Magazin (6) abgelegten Wafer (7) vorgesehen.

Beispielsweise mit einer einfachen Lichtschranke (13, 15) können so alle Wafer überwacht werden, die in einem Magazin (6) mit mehreren Fächern übereinander abgelegt sind. Auf diese Weise können nicht nur die Wafer (7) überwacht werden, die gerade mittels des Transportroboters (3) entnommen oder abgelegt werden, sondern auch alle anderen im Magazin (6) befindlichen Wafer (7).

## Beschreibung

Die Erfindung betrifft einen Reaktor zur Verarbeitung von Wafern mit wenigstens einer Prozeßkammer, wenigstens einer Transportkammer mit einem Transportroboter für die Wafer und wenigstens einem Magazin für Wafer mit einem Hebemechanismus.

Bekannte Anlagen zur Halbleiterverarbeitung bestehen meist aus einem Reaktor mit mehreren Prozeßkammern und einer Transportkammer. Daran gekoppelt ist eine Be- und Entladeeinheit. Die Halbleiterscheiben (Wafer) werden mittels eines Transportroboters, der in der Transportkammer angeordnet ist, aus einer Speichereinheit mit einem Magazin für mehrere Wafer und mit einem Hebemechanismus entnommen und über die Transportkammer in eine der Prozeßkammern geladen. Der Roboter läd den Wafer nacheinander in verschiedene Prozeßkammern, in denen er verschiedenen Prozessen ausgesetzt wird. Dabei werden die Prozeßkammern auch gleichzeitig von verschiedenen Wafern belegt, die zwischen zwei Prozessen (z. B. bei belegter Prozeßkammer) oder nach dem letzten Prozeß wieder im Magazin der Speichereinheit abgelegt werden. Da sich im gesamten Reaktor ein Vakuum befindet und die einzelnen Kammern durch Ventile verschlossen werden können, können diese Prozesse automatisiert ablaufen, ohne daß ein Wafer an Atmosphäre kommt.

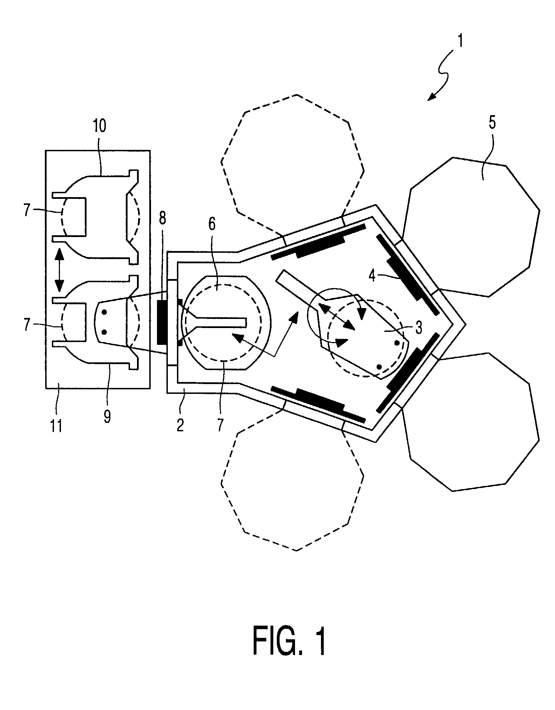

Aus der amerikanischen Patentschrift US 4,819,167 ist ein System und eine Methode zur Erkennung des Mittelpunktes einer kreisförmigen Halbleiterscheibe zur Herstellung von integrierten Schaltungen (Wafer 15) bekannt. Die genaue Position eines bewegten Objektes (Wafers) kann dabei während des Transports durch einen Roboter bestimmt werden, um die Genauigkeit dieser Bewegung zu unterstützen. Zur Bestimmung der relativen Lage des Wafers, der sich auf einer entlang eines vorgegebenen Weges bewegbaren Halterung befindet, zu einem ausgewählten Punkt, zu dem die Halterung mit dem Wafer bewegt wird, sind mehrere Sensoren (s. z. B. 61 - 66 in Figur 3 und zugehöriger Beschreibung) vorgesehen. Die Sensoren werden von Anfangs- und Endpunkten des Wafers ausgelöst und liefern entsprechende Signale. Mittels dieser Signale wird die Position berechnet. Insbesondere wird durch eine Anordnung von mehreren optischen Sensoren, die quer zur Bewegungsrichtung angeordnet sind, die Position eines bewegten Wafers relativ zu einer internen Speichereinheit mit einem Magazin mit Hebemechanismus (internal storage elevator 19) bestimmt. Die Sensoren sind in einer Reihe senkrecht zur Bewegungsrichtung der Halterung an einem Eingangsschlitz innerhalb einer Transportkammer (vacuum loadlock chamber 11) befestigt (s. beispielsweise 47 in Figur 1, 2, 3 und 5), in der sich die interne Speichereinheit befindet. Zur Ermittlung des Mittelpunktes des Wafers sind mehrere Sensoren notwendig, anhand derer Signale dann eine aufwendige Berechnung durchgeführt wird. Zudem wird die Position des Wafers nur während des Transports durch die Halterung bis zur internen Speichereinheit bestimmt. Mit dem angegebenen System kann nur sichergestellt werden, daß der Wafer sich in einer bestimmten Position zur Halterung befindet, wenn er sich auf der Halterung befindet (Spalte 1, Zeile 35-55).

Des weiteren ist in der amerikanischen Patentschrift US 5,563,798 ein Wafer-Positionierungssystem für eine automatisierte Waferbearbeitungsanlage (Reaktor) mit mehreren Prozeßkammern (processing chambers 6) offenbart. Dabei wird die Position des Wafers (10) bestimmt, indem die Position eines Wafertransportroboters (wafer transport robot 18) angezeigt wird, während der Wafer durch ihn bewegt wird. Dazu sind Sensoren an einem durchsichtigen Deckel einer zentral angeordneten Transportkammer (transfer chamber 16) angebracht. Der Lichtstrahl der optischen Sensoren führt durch den Deckel und die Transportkammer auf an deren Boden angebrachte Reflektoren, die den Strahl zurückreflektieren. Ein Detektor im Sensor erkennt, wenn ein durch die Transportkammer bewegter Wafer den Lichtstrahl unterbricht. Dann wird die Position des Wafertransportroboters anhand von wenigstens zwei Meßwerten gemessen und bei Abweichung von der korrekten Position der Wafertransportroboter entsprechend nachgestellt. Dazu wird anhand der Meßwerte durch eine aufwendige Berechnung die Lage des Wafers berechnet und die Abweichung von der korrekten Lage durch eine lineare und rotatorische Verstellung des Wafertransportrobotors kompensiert. Damit soll erreicht werden, daß der Wafertransportroboter den Wafer in seine nächste Position innerhalb des Reaktors korrekt transportiert.

Verfahren und Anordnungen nach dem Stand der Technik haben den Nachteil, daß jeweils lediglich die Position des gerade transportierten Wafers beobachtet und kontrolliert bzw. korrigiert werden kann. Außerdem kann damit höchstens eine Kontrolle für den Augenblick der Messung erfolgen. Aus den Meßergebnissen müssen Korrekturstellgrößen für den Transportroboter errechnet werden, die ebenfalls nur momentan, ohne weitere, ungewollte Bewegungen des Wafers, gelten. Dabei kann es dennoch zur Zerstörung von Wafern kommen, die insbesondere in einer internen oder externen Speichereinheit in einem Magazin abgelegt sind. Beispielsweise aufgrund von translatorischen Bewegungen der externen Speichereinheit bei einem Magazinwechsel können die abgelegten Wafer verrutschen und dann bei einer folgenden vertikalen oder horizontalen Verstellung des Magazins durch den Hebemechanismus zerstört werden.

Aufgabe der Erfindung ist es daher, eine Anordnung zu schaffen, die einen besseren Schutz vor Beschädigung auch von in einem Magazin abgelegten Wafern gewährleistet.

Die Aufgabe der Erfindung wird dadurch gelöst, daß im Reaktor eine optische Kontrollanordnung zur Überwachung der Position der in einem Magazin abgelegten Wafer vorgesehen ist. Die optische Kontrollanordnung, die insbesondere aus einer aus Sender (LED) und Empfänger (Photodiode) gebildeten Lichtschranke bestehen kann, ist erfindungsgemäß innerhalb des Reaktors angebracht. Bei geeigneter Anordnung können so alle Wafer überwacht werden, die darin in einem Magazin mit mehreren Fächern übereinander abgelegt sind. Auf diese Weise können nicht nur die Wafer überwacht werden, die gerade mittels des Transportroboters entnommen oder abgelegt werden, sondern auch alle anderen im Magazin befindlichen Wafer. Wenn die Position eines Wafers im Magazin verschoben ist, würde eine Betätigung des Hebemechanismus bei zu geringem Abstand zur Wand zur Beschädigung des Wafers führen. Insbesondere dann, wenn der Wafer von einem breiteren in einen schmaleren Bereich bewegt würde. Da vor allem die früher abgelegten Wafer durch häufiges Ent- und Beladen und Verfahren des Magazins durch Erschütterungen verschoben werden können, ist die Kontrolle dieser Wafer von entscheidender Bedeutung. Das gilt insbesondere, wenn mehrere Magazine vorhanden sind, auf die nacheinander zugegriffen werden kann. Dann kann es beim Verfahren der Magazine zusätzlich zu Beschädigungen kommen. Die Limitierung der Überwachung der Position auf den Wafer, der gerade mittels des Transportroboters bewegt wird, führt zu häufigen Waferbeschädigungen und ist daher unzureichend. Nur eine erfindungsgemäße Kontrollanordnung schafft eine zuverlässige Überwachung auch solcher Wafer, deren Bearbeitung im Reaktor abgeschlossen ist. Diese sind meist in einem Magazin abgelegt, das momentan nicht mit der Transportkammer gekoppelt ist, sondern zur Entnahme aus dem Reaktor vorgesehen ist. Da hier eine aufwendige Bearbeitung abgeschlossen ist, sind Beschädigungen aus wirtschaftlichen Gründen besonders nachteilig. Dabei ist zu beachten, daß die Beschädigung eines Wafers meist Folgeschäden durch Splitter an anderen Wafern in diesem Magazin nach sich zieht.

Bevorzugte Ausführungsformen der Erfindung sind in Anspruch 2 und 3 angegeben. Besonders geeignet für den Schutz vor Beschädigungen ist die Überwachung der Einhaltung eines Mindestabstandes der Wafer zu einer das Magazin umgebenden Gehäusewand. Die Kontrollanordnung wechselt in einen Alarmzustand, sobald einer der abgelegten Wafer den Mindestabstand unterschreitet. Der Alarmzustand kann beispielsweise durch Unterbrechung des Lichtstrahls einer Lichtschranke erreicht werden, die dann ein anderes Ausgangssignal hat. In jedem Fall unterscheidet er sich eindeutig von einem normalen Betriebszustand, in dem die Überwachung stattfindet und keine falsche Position festgestellt wurde. Es kommt vor allem dann zu Beschädigungen, wenn ein abgelegter Wafer, der aus seiner korrekten Lage verschoben ist, mit dem Magazin von einem breiteren Bereich in der Speichereinheit in einen schmaleren Bereich verfahren wird und dabei mit der Gehäusewand kollidiert. Daher wird die optische Kontrolle vorteilhafterweise an der Gehäusewand angebracht, die dem Magazin am nächsten liegt, in einem schmalen Bereich der Bewegungsvolumens des Magazins angebracht. Solange kein Wafer im Magazin aus seiner korrekten Position verschoben ist, wird die Kontrolle nicht ausgelöst. In diesem Zustand kann das Magazin durch den Hebemechanismus nach oben oder unten oder zum Wechseln des Magazins horizontal verfahren werden, ohne daß es zu Beschädigungen kommt. Wenn ein Wafer so weit verschoben ist, daß er aus dem Magazin herausragt und den, durch eine geeignete Befestigung der Kontrollanordnung einstellbaren, Mindestabstand zur Wand unterschreitet, wird die Kontrolle ausgelöst. Dann kann insbesondere der Hebemechanismus blockiert werden, durch den sonst ein herausragender Wafer beim Verfahren vom breiten in den schmalen Bereich beschädigt würde.

Eine Ausgestaltung der Erfindung nach Anspruch 4 hat den Vorteil, daß die Lichtschranken auf diese Weise die Seiten des Magazins überwachen, an denen die Wafer in das und aus dem Magazin heraus bewegt werden. Dadurch kommt es hier bevorzugt zu Verschiebungen der Position, die aufgrund der größeren Abstände zu den Gehäusewänden unbemerkt bleiben. Daher sind diese Seiten besonders gefährdete Stellen für eine Beschädigung der Wafer beim Verfahren durch den Hebemechanismus.

In den Ansprüchen 5 und 6 ist eine Weiterführung der Erfindung angegeben. Die Auswerteeinheit empfängt das Kontrollsignal und erzeugt ein oder mehrere entsprechende Steuersignale. Das jeweilige Steuersignal wird an eine Steuereinheit des Reaktors geliefert, die den automatisierten Prozeßablauf regelt. Auf diese Weise kann direkt in die Steuerung des Reaktors eingegriffen werden, um im Alarmzustand der Kontrollanordnung Gegenmaßnahmen, wie beispielsweise das Abschalten der Antriebsmotoren für den Hebemechanismus, durchzuführen. Dabei berücksichtigt die Auswerteeinheit außerdem noch weitere Informationen, wie z.B. die Stellung des Transportroboters, der beim Entnehmen bzw. Ablegen eines Wafers ebenfalls die Kontrolle auslösen könnte. Bei einem Kontrollsignal von mehreren Lichtschranken werden in Abhängigkeit der Teilsignale, die jeweils die Information über die Unterbrechung des Lichtstrahls beeinhalten, verschiedene Steuersignale ausgegeben. Vorzugsweise kann bei einer leichten Verschiebung eines Wafers zunächst eine Kontrolleuchte angeschaltet werden, und erst bei einer kritischen Verschiebung das Steuersignal zum Abschalten der Antriebsmotoren ausgegeben. Dann kann vorteilhafterweise weiterhin ein akustisches und/oder optisches Warnsignal in der Nähe des Reaktors und in einer übergeordneten Ablaufsteuerung erzeugt werden. Die Ablaufsteuerung wird beispielsweise aus einem Computer gebildet, der via LAN mit mehreren verschiedenen Produktionseinheiten verbunden ist.

Eine Ausführungsform der Erfindung soll im folgenden anhand von Zeichnungen näher erläutert werden. Dabei zeigen
- Figur 1:: einen Reaktor zur Verarbeitung von Halbleiterscheiben (Wafern) gemäß dem Oberbegriff nach Patentanspruch 1 und
- Figur 2:: eine schematische Darstellung einer erfindungsgemäßen Speichereinheit mit einem Magazin für Wafer und einem Hebemechanismus im Querschnitt.

Der in Figur 1 dargestellte Reaktor ist beispielsweise auch aus "Vakuumbeschichtung 2" von Uwe Behringer et.al., VDI-Verlag Düsseldorf, 1995 bekannt. Der Reaktor 1 besteht aus einer Transportkammer 2, in der sich ein Transportroboter 3 befindet. Der Transportroboter 3 ist drehbar gelagert und kann radial vor- und zurückbewegt werden. An die zentrale Transportkammer 2 sind jeweils über ein Ventil 4 mehrere Prozeßkammern 5 angekoppelt, die ringförmig um den Transportroboter 3 angeordnet sind. Außerdem ist an einer Stelle im Ring um den Drehpunkt des Transportroboters 3 ein internes Magazin 6 installiert, das mehrere Wafer 7 aufnehmen kann. Die Wafer 7 werden übereinander im internen Magazin 6 abgelegt, das dazu mittels eines Hebemechanismus vertikal verfahren werden kann. Mittels einer Schleuse 8 sind an die Transportkammer 2 hinter dem internen Magazin 6 zwei zusätzliche externe Magazine 9 und 10 für Wafer 7 angekoppelt, die sich in einer externen Speichereinheit 11 befinden. Beide Magazine 9 und 10 besitzen ebenfalls einen Hebemechanismus und nehmen jeweils mehrere Wafer 7 auf. Durch eine horizontale Verschiebung der Speichereinheit 11 kann Magazin 9 oder 10 an die Schleuse 8 bewegt werden, so daß der Transportroboter 3 auf die darin abgelegten Wafer 7 zugreifen kann.

Im gesamten Reaktor 1 befindet sich ein Vakuum, so daß die bearbeiteten Wafer 7 zwischen einzelnen Prozeßschritten nicht mit der Atmosphäre in Kontakt kommen. Die einzelnen Kammern sind mit schlitzförmigen Ventilen 4 voneinander getrennt. Ein oder mehrere Wafer 7 werden in unbearbeiteten Zustand (Rohling) in einem Magazin in die externe Speichereinheit 11 geladen, die dann mit dem Reaktor 1 ein geschlossenes System bildet. Über die Schleuse 8, die die Speichereinheit 11 mit der polygonalen Transportkammer 2 verbindet, kann der Transportroboter 3 die Wafer 7 aus dem Magazin 9 entnehmen. Dazu ist der Transportroboter 3 mit einer Aufnahme, auf der ein Wafer 7 transportiert werden kann, drehbar im Zentrum der Transportkammer 2 angeordnet. Durch Verfahren der Aufnahme in Längsrichtung entnimmt der Transportroboter 3 einen Wafer 7 aus dem Magazin 9 oder dem Magazin 6. Der Wafer 7 wird dann in eine der Prozeßkammern 5 eingelegt, die mit einem Ventil 4 verschlossen werden. Auf diese Weise können in den verschiedenen Prozeßkammern 5 gleichzeitig unterschiedliche Prozesse ablaufen und mehrere Wafer 7 bearbeitet werden. Vorteilhafterweise gehören die Prozesse zu einem Herstellungsschritt, so daß die Wafer 7 nacheinander in die entsprechenden Prozeßkammern 5 eingelegt werden, ohne zwischendurch der Atmosphäre ausgesetzt werden zu müssen. Zwischen den einzelnen Prozessen werden die Wafer 7 im Magazin 6 abgelegt und erst nach dem letzten Prozeß in diesem Reaktor 1 im Magazin 9 abgelegt. Nach der Bearbeitung aller Wafer 7 aus Magazin 9 wird das Magazin 10 an die Schleuse 8 verfahren und daraus der erste Wafer 7 zur Bearbeitung entnommen. In diesem Zustand kann ein Wechsel des Magazins 9 gegen ein neues Magazin mit Rohlingen ermöglicht werden.

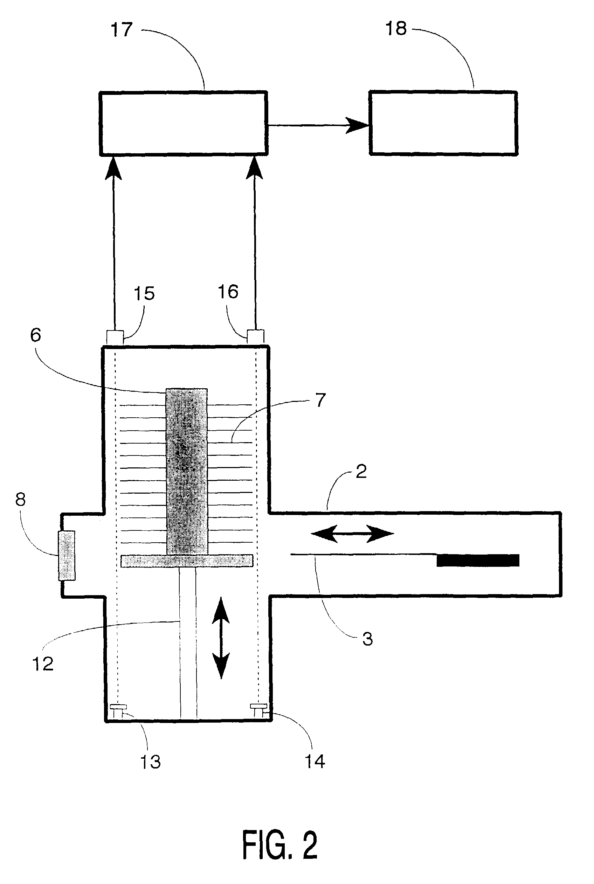

Figur 2 zeigt im Querschnitt das Magazin 6 mit seinem Hebemechanismus 12, das sich in der Transportkammer 2 befindet. Weiterhin ist die Schleuse 8 und der Transportroboter 3 dargestellt, der Wafer 7 in das Magazin 6 ablegt und entnimmt. In der Figur 2 befindet sich der Transportroboter 3 in einer zurückgefahrenen Position, in der das Magazin 6 zum Ablegen von Wafern 7 nach oben und unten verfahren werden kann. An der unteren Seite des Reaktors 1 sind zwei Emitterdioden 13 und 14 angebracht, die mit den an der oberen Seite montierten Photodioden 15 und 16 jeweils eine Lichtschranke bilden. Damit gekoppelt sind eine Auswerteeinheit 17 und eine Steuereinheit 18 des Reaktors 1.

Da der Lichtstrahl jeweils parallel zum Magazin 6 verläuft, wird er durch jeden Wafer 7 unabhängig von dessen Größe unterbrochen, wenn er übermäßig weit aus seiner Position verschoben ist. Eine übermäßige Verschiebung eines Wafers 7 im Bereich der Schleuse 8 oder des Transportroboters 3 bereitet aufgrund des größeren Durchmessers des Reaktors 1 noch keine Probleme. Beim Verfahren durch den Hebemechanismus 12 in einen schmaleren Bereich kann es jedoch zu Beschädigungen durch eine Kollision mit der Gehäusewand im Übergangsbereich kommen. Der betroffene Wafer wird zerstört und beschädigt durch absplitternde Bruchstücke andere Wafer im Magazin 6. Durch entsprechende Anordnung der Lichtschranken 13-16 kann ein Mindestabstand eingestellt werden, den ein verschobener Wafer 7 zur Gehäusewand der Transportkammer 2 einhalten muß. Bei Unterschreitung wechselt die entsprechende Lichtschranke in einen Alarmzustand und liefert ein Kontrollsignal, das eine Unterbrechung signalisiert. Das Kontrollsignal wird von der Auswerteeinheit 17 empfangen und ausgewertet. Unter Berücksichtigung weiterer Informationen wird bei Auslösung des Alarmzustandes ein Steuersignal erzeugt, das die Steuereinheit 18 veranlaßt, die Antriebsmotoren für den Hebemechanismus 12 und den Transportroboter 3 zu stoppen. Nach einer Sichtprüfung des Reaktors 1 muß ein manueller Neustart vorgenommen werden. Der Auswerteeinheit 17 müssen weitere Informationen, die den momentanen Prozeßablauf im Reaktor 1 beschreiben, zur Verfügung gestellt werden, weil beispielsweise auch der Transportroboter 3 beim Ablegen und Entnehmen eines Wafers 7 sonst einen Alarmzustand erzeugen würde. Daher wird auf eine Unterbrechung der Lichtschranken 13-16 nur reagiert, wenn sich der Transportroboter 3 in der zurückgefahrenen Position befindet. Zusätzlich signalisiert noch eine nicht dargestellte Kontrolleuchte an der Auswerteeinheit 17 und/oder der Steuereinheit 18 den Alarmzustand.

## Patentansprüche

1. Reaktor (1) zur Verarbeitung von Wafern (7) mit wenigstens einer Prozeßkammer (5), wenigstens einer Transportkammer (2) mit einem Transportroboter (3) für die Wafer (7) und wenigstens einem Magazin (6, 9, 10) für Wafer (7) mit einem Hebemechanismus (12),
dadurch gekennzeichnet,
daß im Reaktor (1) eine optische Kontrollanordnung (13, 14, 15, 16) zur Überwachung der Position der in einem Magazin (6) abgelegten Wafer (7) vorgesehen ist.

2. Reaktor (1) nach Anspruch 1,
dadurch gekennzeichnet,
daß die optische Kontrollanordnung (13, 14, 15, 16) zum Wechsel in einen Alarmzustand bei Unterschreiten eines Mindestabstandes zu einer das Magazin (6) umgebenden Gehäusewand durch wenigstens einen abgelegten Wafer (7) vorgesehen ist.

3. Reaktor (1) nach Anspruch 2,
dadurch gekennzeichnet,
daß wenigstens eine parallel zum Magazin (6) in dem Mindestabstand zu der dem Magazin (6) am nächsten liegenden Gehäusewand angeordnete Lichtschranke (13, 15 bzw. 14, 16) zur Bildung der optischen Kontrollanordnung (13, 14, 15, 16) vorgesehen ist.

4. Reaktor (1) nach Anspruch 3,
dadurch gekennzeichnet,
daß eine erste Lichtschranke (14, 16) an einer ersten Seite des Magazins (6), an der die Ankopplung der Transportkammer (2) vorgesehen ist, und
eine zweite Lichtschranke (13, 15) an einer zweiten Seite des Magazins (6), an der die Ankopplung einer Vorrichtung zum Be- und Entladen des Reaktors vorgesehen ist, angeordnet ist.

5. Reaktor (1) nach Anspruch 4,
dadurch gekennzeichnet,
daß eine Lichtschranke (13, 15) jeweils aus einer Emitterdiode (13), die an der unteren Seite des Reaktors (1) montiert ist und einen gepulsten IR-Lichtstrahl aussendet, und einer Photodiode (15) zum Empfang des gepulsten IR-Lichtstrahls, die an der oberen Seite des Reaktors (1) montiert ist, besteht.

6. Reaktor (1) nach Anspruch 1,
dadurch gekennzeichnet,
daß eine Auswerteeinheit (17) zum Empfang eines von der optischen Kontrollanordnung (13, 14, 15, 16) gelieferten, ihren Zustand kennzeichnenden Kontrollsignals und zur Ausgabe wenigstens eines Steuersignals für eine Steuereinheitb (18) des Reaktors (1) in Abhängigkeit vom Kontrollsignal vorgesehen ist.
